Europäisches Patentamt

European Patent Office

Office européen des brevets

(19)

(11) Numéro de publication : **0 541 653 B1**

(12) **FASCICULE DE BREVET EUROPEEN**

(45) Date de publication du fascicule du brevet :
**04.05.94 Bulletin 94/18**

(51) Int. Cl.$^5$ : **G01R 33/38, H01F 7/02**

(21) Numéro de dépôt : **91914118.4**

(22) Date de dépôt : **25.07.91**

(86) Numéro de dépôt international :
**PCT/FR91/00617**

(87) Numéro de publication internationale :
**WO 92/02827 20.02.92 Gazette 92/05**

(54) **AIMANT PERMANENT POUR INSTALLATION D'IMAGERIE PAR RESONANCE MAGNETIQUE NUCLEAIRE.**

(30) Priorité : **30.07.90 FR 9009698**

(43) Date de publication de la demande :
**19.05.93 Bulletin 93/20**

(45) Mention de la délivrance du brevet :
**04.05.94 Bulletin 94/18**

(84) Etats contractants désignés :
**DE GB IT NL**

(56) Documents cités :
**EP-A- 0 167 639**
**WO-A-88/02924**
**FR-A- 2 605 452**
**US-A- 4 816 796**

(56) Documents cités :
**PROCEEDINGS OF THE 7TH ANNUAL CONFE-
RENCE OF THE IEEE/ENGINEERING IN MEDI-
CINE AND BIOLOGY SOCIETY Vol. 1,
September 1985, CHICAGO, USA pages
599-603; J.H. BATTOCLETTI; T.A. KNOX:
"NMR Imaging: Permanent Magnet Design by
Finite Element Analysis" see pages 600-602,
chapter "Analysis of Various Magnet
Designs" see figures 2, 3**

(73) Titulaire : **CENTRE NATIONAL DE LA
RECHERCHE SCIENTIFIQUE (CNRS)
15, Quai Anatole France
F-75700 Paris Cedex 07 (FR)**

(72) Inventeur : **AUBERT, Guy
26, cours de la Libération
F-38100 Grenoble (FR)**

(74) Mandataire : **Schmit, Christian Norbert Marie
Cabinet Ballot-Schmit 7, rue Le Sueur
F-75116 Paris (FR)**

EP 0 541 653 B1

## Description

La présente invention a pour objet un aimant permanent pour des installations d'imagerie par résonance magnétique nucléaire (RMN). L'aimant dont il est question est l'aimant qui est utilisé, dans une telle installation, pour produire un champ magnétique homogène et intense dans une zone d'intérêt. Dans le domaine médical, un patient est placé dans cette zone d'intérêt. L'invention peut s'appliquer à d'autres domaines, notamment au contrôle industriel. Elle a pour but de produire un champ dit transverse.

On connaît les structures à aimant permanent notamment celles dites du type à aimant-plaque. De telles structures sont par exemple décrites dans la demande de brevet européen EP-A-0 170 318. Ou encore, de telles structures sont décrites dans les brevets américains US 4 672 346, 4 679 022 et 4 818 966. D'autres types de structures à aimant permanent sont aussi déjà connus : notamment un aimant permanent sphérique à accès équatorial décrit dans le brevet français 2 605 452.

L'inconvénient présenté par les structures dites à aimant-plaque se situe dans la fermeture des lignes de champ magnétique. En effet, pour simplifier, dans une structure à aimant-plaque le champ transverse est produit dans un entrefer situé entre deux plaques en matériau aimanté de façon permanente. La face sud d'une plaque est en vis à vis de part et d'autre de l'entrefer, de la face nord de l'autre plaque. La fermeture des lignes de champ magnétique est donc organisée entre les faces les plus éloignées des deux plaques. Pour éviter les effets néfastes sur la valeur du champ produit dans l'entrefer par l'existence de cet autre entrefer de fermeture des lignes de champ, il est habituel de disposer entre ces deux faces éloignées des structures de fermeture en matériau magnétique aimantable, typiquement du fer doux. Ces structures en fer doux présentent plusieurs inconvénients. D'une part, bien que le prix du fer doux soit peu élevé, il grève quand même le prix de l'aimant. En outre, ces structures en fer doux prennent de la place et limitent les accès à la zone utile d'entrefer. L'idéal serait de refermer les lignes de champ partout, mais dans ce cas on ne peut plus entrer dans la zone d'intérêt de l'aimant.

En outre, les solutions ainsi imaginées ne conduisent pas à une bonne homogénéité du champ magnétique intense dans la zone d'intérêt d'une part, et sont d'autre part des lieux privilégiés de naissance de courants de Foucault au cours des séquences d'excitations-mesures du signal de RMN utilisées dans les procédés d'imagerie. L'homogénéité n'est pas bonne car elle ne peut être qu'empirique. En effet, ces structures en fer doux qui servent également au maintien des plaques d'aimant ont des formes imposées par des considérations de mécanique qui ne se prêtent pas à une modélisation analytique précise de leur contribution au champ magnétique. On ne peut qu'utiliser des techniques de calcul par éléments finis qui n'ont pas une précision suffisante eu égard à l'homogénéité du champ requise par la RMN.

Il reste donc que la validation empirique du champ réellement créé s'impose. Cette validation empirique nécessite, d'imaginer la mise en place de pièces de fer doux à certains endroits privilégiés, de mesurer les effets de cette mise en place et d'effectuer la modification consécutive jusqu'à ce que, petit à petit, l'homogénéité requise soit atteinte. Cette technique empirique n'est pas une technique industrielle : elle nécessite des compétences très élevées pour fabriquer un seul exemplaire et elle n'est pas facilement reproductible.

En ce qui concerne les courants de Foucault, les caractères impulsionnels des gradients de champ magnétique supplémentaire appliqués au cours des séquences d'excitation-mesure du signal RMN dans les examens s'opposent à une telle solution, parce que le fer doux est conducteur. Dans l'invention, comme on le verra plus loin, on utilise une structure sans fer doux, qui met en oeuvre uniquement des blocs d'aimants par ailleur calculables analytiquement. Si ces blocs d'aimants sont à base de ferrite, ils sont eux mêmes des isolants et ne sont donc pas le siège de courants de Foucault.

Dans le brevet français concernant l'aimant permanent sphérique à accès équatorial cité ci-dessus, on avait réalisé une structure symétrique à base d'anneaux de forme générale hémisphérique produisant un champ transverse. L'inconvénient présenté par cette structure se situe dans le fait que, d'une part le maintien et le réglage des anneaux sphériques les uns par rapport aux autres n'est mécaniquement pas simple. Et surtout, d'autre part, que la zone d'intérêt dans laquelle le champ est homogène est bien plus grande que la dimension de l'accès à cette zone. Autrement dit les deux structures hémisphériques creuses dégagent en leur intérieur une grande zone d'intérêt à haute homogénéité.

Par contre, l'accès à l'intérieur est étroit : c'est comme si on considérait que ces structures n'étaient pas assez espacés l'une de l'autre afin qu'il soit facile de s'y glisser à l'intérieur. En pratique, les machines médicales réalisées avec cette invention sont mal adaptées à l'examen des patients adultes. En outre, l'aimantation des blocs magnétiques servant à réaliser les anneaux de cette structure sphérique devait avoir une orientation fonction de la position de ces blocs. Cette position était repérée sur un cercle dont un des diamètres est perpendiculaire au plan de l'accès équatorial de cet aimant. Il en était de même de la valeur des aimantations de ces blocs. Ceci conduisait à des difficultés de réalisations des blocs.

Dans l'invention, on remédie à ces inconvénients en proposant une structure beaucoup plus simple que la structure sphérique à accès équatorial, dont la zone d'intérêt est accessible en entier, et qui ne nécessite pas par ailleurs la présence de fer doux pour assurer le retour des lignes de champ magnétique. La solution inventée consiste, au lieu de réaliser des plaques aimantées monoblocs avec un pôle nord et un pôle sud, à remplacer ces plaques par des couronnes, concentriques les unes aux autres, et dans lesquelles la distribution non uniforme de l'aimantation est telle qu'elle conduit en elle même à une grande homogénéité du champ produit. Avec les couronnes, on est capable de créer localement une très grande homogénéité. On utilise dans ce but des blocs avec des formes, des positions, et des aimantations calculées pour produire l'homogénéité d'une part et d'autre part, dans un mode préféré, une fermeture plus facile des lignes de champ.

L'invention a donc pour objet un aimant permanent pour installation d'imagerie par résonance magnétique nucléaire, comportant un ensemble de couronnes de blocs aimantés pour produire un champ magnétique intense et homogène dans une région de l'espace, ces couronnes étant réparties en deux jeux de couronnes complémentaires ladite région de l'espace étant située entre ces deux jeux, caractérisé en ce que les couronnes d'un jeu sont toutes sensiblement concentriques, chaque couronne d'un jeu étant séparée de sa couronne complémentaire dans l'autre jeu en vis a vis par une hauteur de cette région, cette hauteur étant sensiblement la même pour tous les couples de couronnes complémentaires.

L'invention sera mieux comprise à lecture de la description qui suit des figures qui l'accompagnent. Celles-ci ne sont données qu'à titre indicatif et nullement limitatif de l'invention.

Figures 1-a, 1-b, 2 et 3 : des exemples de réalisation d'aimants conforme à l'invention ;

Figures 4, 5 et 6 : des dimensions et espacements montrant, pour les exemples précédents, comment répartir les blocs magnétiques dans les couronnes.

Comme on le verra par la suite, l'ordre d'homogénéité auquel doivent satisfaire les structures selon l'invention doit être grand. En effet, le fait de disposer d'une grande structure magnétique a immédiatement pour conséquence que, sur une petite dimension donnée dans la zone d'intérêt de cette structure magnétique, les variations du champ, l'inhomogénéité sont moins grandes que si la structure magnétique était plus petite, et qu'on regardait ce qui se passe sur la même petite dimension donnée. Ainsi, dans les aimants de type supraconducteur, ou même résistif, de l'état de la technique, compte tenu de la place nécessaire pour glisser le patient à l'intérieur de la machine, et pour mettre en place les diverses bobines de gradients et antennes d'émission-réception, le diamètre intérieur utile des aimants cylindriques est de l'ordre de 1 mètre. Dans ces conditions, il suffit de réaliser une homogénéité du champ magnétique au huitième ordre (le premier ordre non nul est le dixième). Dans les trente centimètres utiles de la zone d'intérêt, ces inhomogénéités sont, pour simplifier, multipliées par un facteur $(0,3/1,00)^{10} = 5,9.10^{-6}$. Elles sont donc relativement réduites.

Par contre, dans les structures comme celles de l'invention, où la dimension utile (0,30m) de la zone d'intérêt est sensiblement du même ordre que l'espace logistique entre les "plaques" d'aimants, de l'ordre de 0,50m, l'homogénéité analytique doit être plus élevée. On doit atteindre par exemple le quatorzième ordre. La nécessité de réduire l'espace logistique au minimum résulte de ce que le volume de matériau magnétique augmente comme le cube de cet espace logistique. Dans l'invention, on n'augmente pas l'espace logistique mais au contraire, avec une solution d'une distribution différente de l'aimantation dans les "plaques", on augmente l'ordre d'homogénéité. On obtient ainsi des plaques magnétiques dont le volume de matériau est comparable aux aimant-plaques connus et avec cependant une très bonne homogénéité.

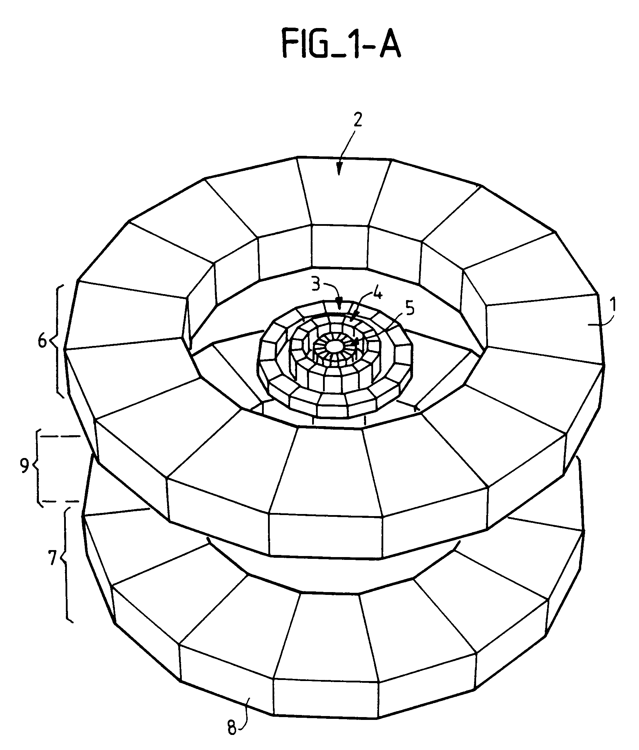

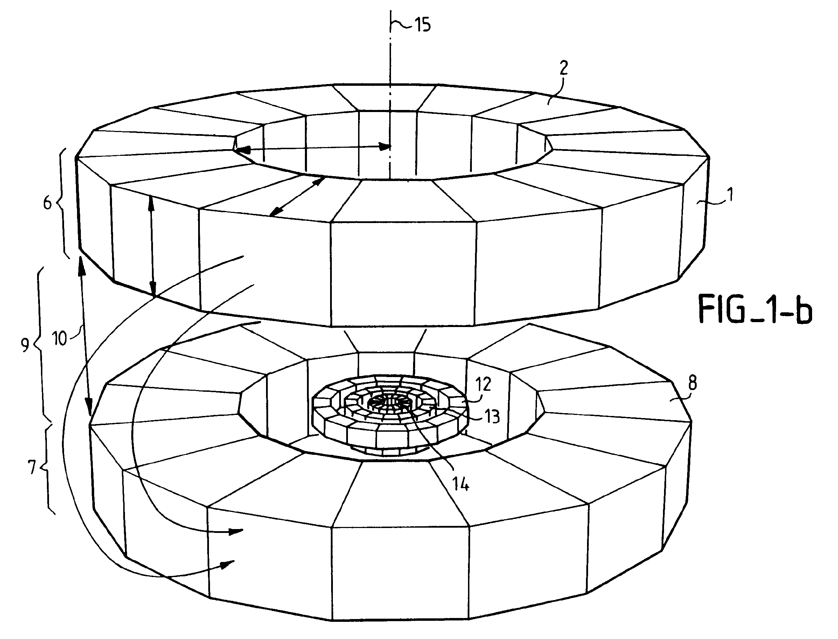

La même structure montrée en perspective sur les figures 1a et 1b, respectivement en oblique descendante et sensiblement dans un plan transverse, est susceptible de donner un champ de 0,2 tesla dans son entrefer. Elle est composée de blocs magnétiques tel que 1, qui dans un exemple préféré sont en Fer Néodyme Bore : FeNdB. Si on appelle Br l'induction rémanente à l'intérieur d'un tel matériau magnétique aimanté à saturation la structure ainsi produite est telle que la valeur $B_0$ (O,2 tesla) produite est sensiblement égale à O,17 Br. Par ailleurs on ne rencontre pas dans le matériau d'excitation démagnétisante supérieure en valeur absolue à 0,7 fois l'excitation coercitive de ce matériau. Il n'y a donc pas d'effet démagnétisant. En pratique, la structure des figures la et lb pèse environ 3 tonnes.

L'aimant permanent ainsi décrit comporte un ensemble de couronnes, par exemple les couronnes 2,3,4,5. Ces couronnes sont réparties en deux jeux, respectivement 6 et 7 de couronnes complémentaires. Par exemple, la couronne 8 dans le jeu 7 est complémentaire de la couronne 2 dans le jeu 6. Les couronnes d'un même jeu, par exemple les couronnes 2,3,4 et 5 dans le jeu 6 sont toutes sensiblement concentriques. Ceci signifie, d'une part que les couronnes ont un même axe 15 de révolution et que, d'autre part, elles sont entièrement imbricables l'une dans l'autre. En pratique, ceci signifie que la plus grande couronne d'un jeu, dans le cas présent la couronne 2, peut contenir toutes les autres du même jeu. En outre, dans l'invention chaque couronne d'un jeu est séparée de sa couronne complémentaire dans l'autre jeu, par exemple les couronnes 2 et 8, par une même hauteur 10 de la région 9 de l'espace entre ses couronnes, où règne le champ magnétique intense et homogène.

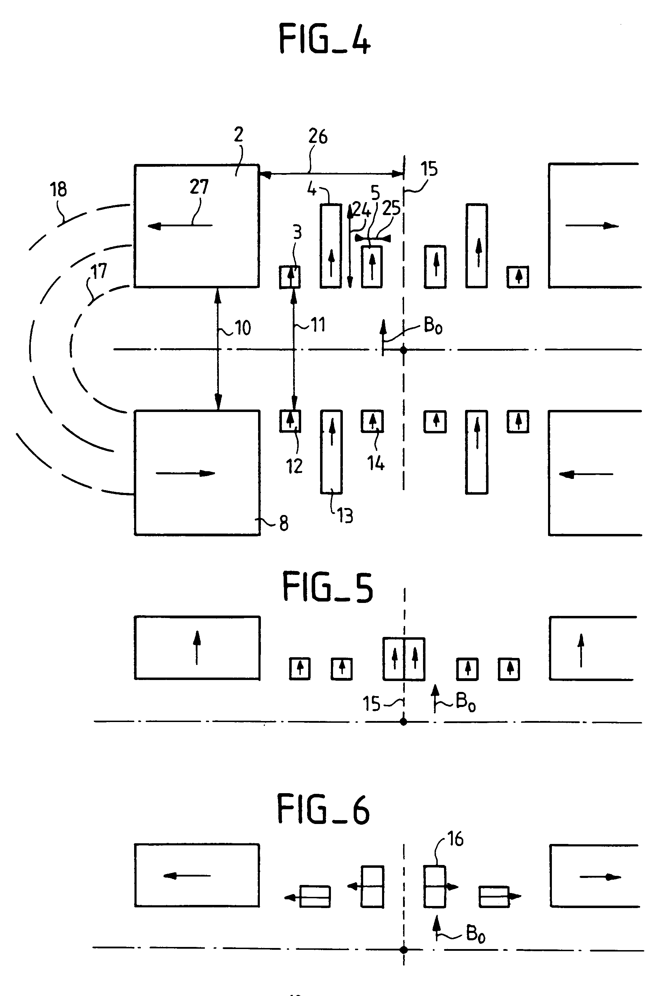

La hauteur qui sépare deux couronnes complémentaires est sensiblement la même pour tous les couples de couronnes complémentaires des jeux de couronnes de l'aimant. Ces particularités de dimensions apparaîtront par ailleurs mieux sur la figure 4. Celle-ci est une vue en coupe, selon un plan coupant radialement toutes les couronnes de la figure 1a ou de la figure 1b.

La hauteur est la hauteur 10 qui sépare la couronne 2 de la couronne 8. Cette hauteur 10 est sensiblement égale à la hauteur 11 qui sépare la couronne 3 de la couronne 12 et ainsi de suite pour les couronne 4 et 5 et leurs couronnes respectivement complémentaires 13 et 14. La figure 1b montre les mêmes éléments ainsi que l'axe de révolution 15. La hauteur mesure l'écart entre les faces en vis à vis de l'entrefer.

On sait, depuis le dépôt le 14 décembre 1984 de la demande de brevet français 84 19191, exprimer, en valeur relative, la valeur du champ magnétique induit, dans un système de coordonnées polaires normalisé par un rayon $r_0$ définissant les frontières du volume utile dans lequel on obtient l'homogénéité requise. Cette expression peut s'écrire dans la façon suivante :

$$\frac{B_z}{B_0} \; = \; 1 \, + \, \sum_{\substack{n=1}}^{\infty} \, \left( \frac{r}{r_0} \right)^n \cdot \, H_n \, \cdot \, P_n \, ( \, \cos \, \theta \, )$$

$$+ \, \sum_{m=1}^{n} \, ( \, I_n{}^m \cos \, m\Phi \, + \, J_n{}^m \sin \, m\Phi \, ) \; P_n{}^m \, ( \, \cos \, \theta \, )$$

Dans cette expression, les polynômes $P_n (\cos \Theta)$ et $P_m{}^m (\cos \Theta)$, sont les polynômes de Legendre respectivement de première et de deuxième espèce. L'écart exprimant l'inhomogénéité, par rapport à la valeur 1 pour $B_z/B_0$, est donné par la valeur des coefficients $H_n$, $I_n{}^m$ et $J_n{}^m$. Le champ $B_z$ à une distance r du centre de la zone d'intérêt sera d'autant plus homogène que ces coefficients sont nuls jusqu'à des valeurs élevées de n. On dit alors que le champ est homogène à l'ordre n, si tous les termes de la série, d'ordres inférieurs ou égaux à n, sont nuls. On appelle n l'ordre d'homogénéité.

La structure présentée est une structure homogène au quatorzième ordre. Elle procure une homogénéité supérieure à 1 ppm dans un volume utile dont la hauteur est sensiblement supérieure à la moitié de la hauteur 10. Avoir une homogénéité supérieure à 1ppm veut dire qu'en tous endroits de la région utile de l'ouverture 6 la valeur du champ ne s'éloigne pas, relativement, de plus de 1 millionième de celle de 0,2 tesla.

Le champ $B_0$ créé a une orientation transverse : il est colinéaire à l'axe 15. Dans la solution représentée, l'aimantation dans les couronnes 3, 4 et 5 est également transverse. Par contre, l'aimantation dans la couronne 2 est radiale. Dans les couronnes 12, 13 et 14 l'aimantation est également transverse, de plus elle est orientée dans le même sens que l'aimantation dans les couronnes correspondantes respectivement 3, 4 et 5. Par contre, dans la couronne 8, l'aimantation est radiale mais centripète alors qu'elle est radiale centrifuge dans la couronne 2. La structure des figures 1-a, 1-b et 4 est donc une structure à aimantation mixte.

Ces structures à aimantation mixte sont intéressantes en ce sens que la fermeture des lignes de champ telles que 17 et 18 est assurée au plus près. En particulier le champ créé à l'extérieur de la structure de la figure 4 décroît très vite quand on s'en éloigne. En d'autres termes, il est possible de permettre à des porteurs d'appareil de stimulation cardiaque de s'approcher de cet aimant, sans qu'ils aient à craindre un blocage de leur stimulateur du fait de la présence d'un trop grand champ magnétique de fuite. La structure mixte ainsi présentée est une solution préférée de l'invention. On a ainsi pu calculer qu'à une distance de trois mètres de l'aimant, on avait à subir un champ de l'ordre de deux gauss soit, seulement sensiblement quatre fois le champ magnétique terrestre.

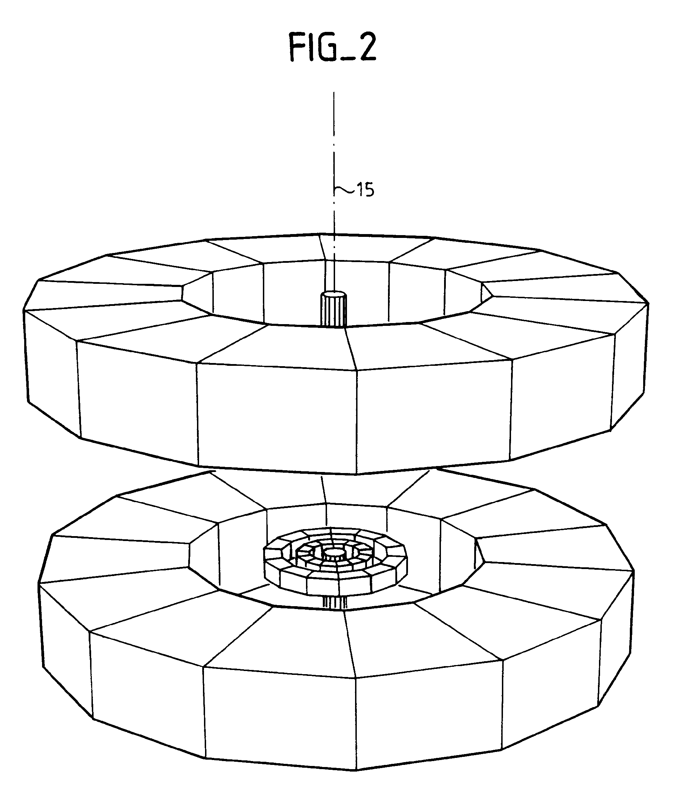

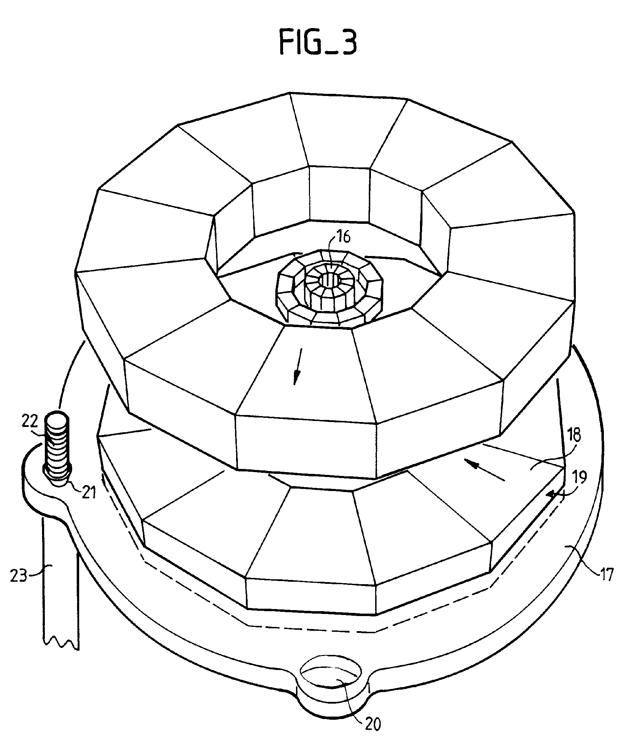

Les figures 2 et 3, en association avec les figures correspondantes 5 et 6 vues en coupes, montrent deux autres exemples de réalisation d'une structure d'aimant selon l'invention. Dans la structure de la figure 2, l'aimant présenté a également quatre couronnes, mais offre la particularité d'avoir une couronne centrale qui obture complètement le trou à l'endroit de passage de l'axe 15. La structure la figure 3 est par contre une structure à seulement trois couronnes, dont la couronne centrale 16 est elle aussi creuse.

Comme on l'expliquera par la suite, en fonction de l'expression donnée ci-dessus, le fait que cette structure ne comporte que trois couronnes a pour conséquence qu'elle produit un champ magnétique moins homogène. Elle est cependant moins exigeante en quantité de matériau magnétique. La structure de la figure 2 est une structure dans laquelle tous les blocs magnétiques ont une aimantation transverse, un peu à la manière de ce qui était connu dans les aimants plaques de l'état de la technique. Cependant, par opposition à ce qui était connu dans cet état de la technique, l'homogénéité du champ $B_0$ est obtenu dans l'espace 9 par des dimensions particulières des différentes couronnes. Elle n'est pas produite par une aimantation uniforme de pièces polaires et des pièces de fermetures du champ qui seraient en fer doux. Dans la structure de la figure 3, les orientations sont radiales, centrifuges sur la partie montrée, elles seraient centripètes sur la partie complémentaire non montrée. L'homogénéité est là aussi réalisée par les différentes tailles des blocs.

La figure 3 montre par ailleurs, une ceinture 17, en matériau non magnétique et donc ne déformant pas l'homogénéité du champ magnétique produit. La ceinture 17 qui peut être en alliage léger, en bois, en matière plastique, ou en béton, de préférence alors armé en fibres de verre, sert à sertir l'ensemble des blocs tels que 18 de la couronne 19. L'aimantation radiale est également montrée sur le bloc 18. La ceinture 17 est par ailleurs munie de trous tels que 20 et 21 de forme oblongue. Ces trous permettent l'engagement d'une tête filetée telle que 22, et une pièce de maintien 23. En présentation horizontale de la zone utile 9 de l'aimant, les couronnes sont sensiblement parallèle au sol. Les pièces 23 relatives aux couronnes inférieures de l'aimant sont fixées au sol. Des pièces complémentaires, pour les couronnes complémentaires supérieures, peuvent être fixées au plafond de la salle dans laquelle est installée la structure. La forme oblongue des trous 20 et 21 permet de déplacer légèrement en translation ou rotation dans leurs plans, mais dans n'importe quel sens, les couronnes telles que 19 de manière à fournir des degrés de liberté, aux mouvements à ces couronnes, afin de servir au réglage fin de l'homogénéité si nécessaire. Par ailleurs, les têtes filetées 22 peuvent être munies à leur partie inférieure d'écrous filetés sur lesquels repose la ceinture 17. Ces écrous servent à régler le parallélisme des couronnes.

En ce qui concerne la couronne extérieure, la ceinture 17 doit être dimensionnée pour supporter des forces magnétiques importantes par ailleurs facilement calculables. En ce qui concerne les petites couronnes concentriques intérieures aux grandes couronnes, les efforts sont moins importants. Pour le maintien de ces couronnes intérieures, plutôt que de réaliser des ceintures indépendantes, à chaque fois, il est possible de noyer dans un moule l'ensemble de ces couronnes, par exemple 12 à 14 et 3 à 5, respectivement dans une matière d'enrobage, par exemple en résine polymérisable. Ces ensembles peuvent eux aussi être maintenus par des systèmes indépendants et réglables. Les espaces entre le couronnes permettent un accès logistique facile.

Le tableau suivant donne pour les ordres d'homogénéités $2p_0$ donnés, ordre du premier terme non nul égal à $2(p_0+1)$, le nombre de couronnes nécessaires ainsi que, dans chaque couronne, polygonale régulière, le nombre minimum de côtés du polygone que celle-ci doit comporter pour que l'homogénéité recherchée soit obtenue.

| $2\,p_0$ | $n_c$ | trou central | $n_b$ |
|---|---|---|---|
| 2 | 1 | non | 4 |
| 4 | 2 | oui | 6 |
| 6 | 2 | non | 8 |
| 8 | 3 | oui | 10 |
| 10 | 3 | non | 12 |
| 12 | 4 | oui | 14 |
| 14 | 4 | non | 16 |

La première colonne donne l'ordre d'homogénéité. La seconde indique le nombre de couronne minimum nécessaire pour atteindre cette homogénéité. La quatrième colonne donne le nombre minimum de côtés par couronnes polygonales pour atteindre cette homogénéité. Les aimantations rémanentes dans les blocs peuvent être les mêmes. Les tailles des blocs sont alors données ci-après pour un exemple en application de l'expression analytique donnée ci-dessus.

Dans un exemple, correspondant à la figure 1, on a ainsi pu déterminer les hauteurs 24, les épaisseurs 25 et le diamètre intérieur 26 de chacune des couronnes de la "plaque". Ces dimensions relatives à la demi ouverture (la hauteur 10 est donc égale à 2) sont données dans le tableau suivant

| | Cour. 2 | Cour. 3 | Cour. 4 | Cour. 5 |
|---|---|---|---|---|
| Hauteur 24 | 0,657 | 0,187 | 0,298 | 0,270 |
| Epaisseur 25 | 1,288 | 0,200 | 0,150 | 0,135 |
| Rayon intérieur 26 | 1,709 | 0,685 | 0,372 | 0,111 |

L'intensité de l'aimantation 27 est la même dans tous les blocs. Ces résultats sont déduits de l'enseignement de la demande de brevet citée ci-dessus. On s'est rendu compte qu'il était nécessaire, puisqu'on évaluait par calcul des couronnes en théorie cylindrique, et puisqu'on les réalisait sous la forme polygonale de successions de blocs accolés les uns aux autres, que cette approximation en elle même était génératrice d'inhomogénéités. Par contre, si le nombre de blocs choisi pour simuler une couronne cylindrique est suffisant, on obtient effectivement sur le plan pratique les résultats escomptés en théorie. Cet ordre d'homogénéité est lié au nombre de couronnes de sorte que le nombre de bloc est aussi lié au nombre des couronne comme indiqué au tableau précédent.

Il est néanmoins possible, en jouant sur les hauteurs, épaisseurs et diamètres intérieurs des blocs d'une couronne, d'obtenir, en application de la décomposition analytique précédente, un aimant de qualité requise. L'aimant décrit est un aimant optimal, c'es-à-dire utilisant à chaque fois des matériaux magnétiques aimantés à saturation au maximum de leur possibilité. Dans la réalisation proposée, les blocs ont une forme trapézoïdale, leur petit côté est orienté vers le centre de la couronne, leur grand côté est tourné vers l'extérieur de la couronne. Il est néanmoins possible de remplacer ces blocs trapézoïdaux par des blocs paralélépipèdique rectangulaires, plus faciles à fabriquer mais on obtiendra un champ magnétique plus faible pour le même encombrement hors tout.

Dans les couronnes, les blocs complémentaires possèdent bien entendu des aimantations complémentaire. En pratique, pour simplifier la conception et la réalisation, les couronnes sont réalisées pour chacun des deux jeux, en des matériaux de même nature et pour chaque couronne avec des blocs magnétiques de mêmes formes. Il serait cependant possible d'aboutir à des résultats similaires avec des blocs d'allures différentes et avec des aimantations différentes.

La réalisation des blocs avec des aimantations données peut être effectuées de diverses manière. On peut par exemple aimanter de tels blocs à saturation et réduire leur aimantation rémanente en parcourant le cycle d'hystéresis de leur courbe d'aimantation de telle manière que cette aimantation rémanente emprunte une droite de recul différente de celle issue de la saturation. D'une manière préférée on construira des blocs en matière composite comme décrit dans le brevet FR 2 574 980.

## Revendications

1. Aimant permanent pour installation d'imagerie par résonance magnétique nucléaire, comportant un ensemble (6,7) de couronnes (2-5,8,12-14) de blocs aimantés pour produire un champ magnétique intense et homogène dans une région de l'espace, ces couronnes étant réparties en deux jeux (6,7) de couronnes complémentaires ladite région de l'espace étant située entre ces deux jeux, caractérisé en ce que les couronnes d'un jeu sont toutes sensiblement concentriques (15), chaque couronne (8) d'un jeu étant séparée de sa couronne complémentaire (2) dans l'autre jeu en vis a vis par une hauteur (10) de cette région, cette hauteur étant sensiblement la même (11) pour tous les couples de couronnes complémentaires.

2. Aimant selon la revendication 1, caractérisé en ce que les champs magnétiques produits par les blocs d'une couronne sont parallèles aux directions des champs magnétiques produits par les blocs, directement en vis a vis, de la couronne complémentaire de cette couronne.

3. Aimant selon l'une quelconque des revendications 1 à 2, caractérisé en ce que les couronnes de plus grand diamètre de chacun des jeux de couronnes sont munies de blocs dans lesquels l'orientation de l'aimantation est radiale (27) par rapport à cette couronne.

4. Aimant selon l'une quelconque des revendications 1 à 3, caractérisé en ce que les couronnes internes de chacun des jeux de couronnes sont munies de blocs dans lesquels l'orientation de l'aimantation est transverse par rapport aux plans de ces couronnes.

5. Aimant selon l'une quelconque des revendications 1 à 4, caractérisé en ce que les couronnes internes de chacun des jeux de couronnes sont chacune munie d'un trou central.

6. Aimant selon l'une quelconque des revendications 1 à 5, produisant un champ magnétique homogène à un ordre $2p_0$, c'est à dire tel que son expression analytique ne comporte pas de terme à un ordre égal ou inférieur à $2 p_0$, caractérisé en ce que les couronnes ont une structure polygonale régulière réalisée par des ensembles de blocs comportant à chaque fois au moins $2(p_0 +1)$ blocs.

7. Aimant selon l'une quelconque des revendications 1 à 6, caractérisé en ce que les couronnes comportent des blocs, le nombre de bloc dans une couronne étant sensiblement supérieur ou égal à 4 fois le nombre de couronne dans un jeu.

## Patentansprüche

1. Permanentmagnet für Vorrichtung zur Bilderzeugung mit magnetischer Kernresonanz, umfassend eine Anordnung (6, 7) von Ringen (2-5, 8, 12-14) aus magnetischen Blöcken für die Erzeugung eines intensiven und homogenen Magnetfeldes in einem Zwischenraumbereich, wobei die Ringe in zwei komplementären Ringgruppen (6, 7) verteilt sind und der Zwischenraumbereich sich zwischen den beiden Gruppen befindet, dadurch gekennzeichnet, daß die Ringe einer Gruppe alle im wesentlichen konzentrischen (15) sind, wobei jeder Ring (8) der einen Gruppe von seinem komplementären, gegenüberliegenden Ring (2) in der anderen Gruppe durch eine Höhe (10) des Zwischenraumes getrennt ist und wobei diese Höhe für alle komplementären Paare im wesentlich gleich (11) ist.

2. Magnet nach Anspruch 1, dadurch gekennzeichnet, daß die von den Blöcken eines Ringes erzeugten Magnetfelder parallel zu den Richtungen der magnetischen Felder sind, die von den Blöcken erzeugt werden, welche in dem zu diesem Ring komplementären Ring direkt gegenüberliegen .

3. Magnet nach Anspruch 1 oder 2, dadurch gekennzeichnet, daß die im Durchmesser größten Ringe einer jeder Gruppe von Ringen mit Blökken bestückt sind, bei denen die Magnetisierungsrichtung radial (27) in bezug auf diesen Ring ist.

4. Magnet nach einem der Ansprüche 1 bis 3, dadurch gekennzeichnet, daß die inneren Ringe einer jeder Ringgruppe mit Blöcken bestückt sind, bei denen die Magnetisierungsrichtung quer in bezug auf die Ebene dieser Ringe ist.

5. Magnet nach einem der Ansprüche 1 bis 4, dadurch gekennzeichnet, daß die inneren Ringe einer jeden Ringgruppe mit einem zentralen Loch versehen sind.

6. Magnet nach einem der Ansprüche 1 bis 5, welcher ein homogenes Magnetfeld der Ordnung $2p_0$ erzeugt, d.h. so groß, daß sein analytischer Ausdruck keinen Ausdruck in der Größe aufweist, der gleich oder kleiner als $2p_0$ ist, dadurch gekennzeichnet, daß die Ringe eine regelmäßige polygonale Struktur haben, die durch die Blöckeanordnungen realisiert ist, die jeweils mindestens 2 ($p_0$ + 1) Blöcke umfassen.

7. Magnet nach einem der Ansprüche 1 bis 6, dadurch gekennzeichnet, daß die Ringe Blöcke umfassen, wobei die Blockzahl in einem Ring im wesentlichen größer oder gleich 4 mal der Ringzahl in einer Gruppe ist.

## Claims

1. Permanent magnet for equipment for imaging by nuclear magnetic resonance, including an assembly (6, 7) of rings (2-5, 8, 12-14) of magnetised blocks for producing an intense homogeneous magnetic field in a region in space, these rings being divided into two sets (6, 7) of complementary rings, the said region in space being situated between these two sets, characterised in that the rings in one set are substantially concentric (15), each ring (8) in a set being separated from its complementary ring (2) in the other facing set by a height (10) in this region, this height being substantially the same (11) for all pairs of complementary rings.

2. Magnet according to Claim 1, characterised in that the magnetic fields produced by the blocks in one ring are parallel to the directions of the magnetic fields produced by the blocks, directly facing, in the ring which is complementary to this ring.

3. Magnet according to either one of Claims 1 to 2, characterised in that the rings with the largest diameter in each of the sets of rings have blocks in which the orientation of the magnetisation is radial (27) with respect to this ring.

4. Magnet according to any one of Claims 1 to 3, characterised in that the inner rings in each of the sets of rings have blocks in which the orientation of the magnetisation is at right angles to the planes of these rings.

5. Magnet according to any one of Claims 1 to 4, characterised in that the inner rings in each of the sets of rings each have a central hole.

6. Magnet according to any one of Claims 1 to 5, producing a homogeneous magnetic field to an order $2p_0$, that is to say such that its analytical expression does not include any term to an order equal to or less than $2p_0$, characterised in that the rings have a regular polygonal structure produced by the assemblies of blocks including, each time, at least $2(p_0 + 1)$ blocks.

7. Magnet according to any one of Claims 1 to 6, characterised in that the rings include blocks, the number of blocks in a ring being approximately greater than or equal to four times the number of rings in a set.

# FIG_1-A

FIG_1-b

EP 0 541 653 B1

# FIG_2

~15

# FIG_3

# FIG_4

# FIG_5

# FIG_6